# EUROPÄISCHE PATENTSCHRIFT

(11) **EP 3 826 880 B1**
(45) Veröffentlichungstag und Bekanntmachung des Hinweises auf die Patenterteilung: **01.03.2023**
(21) Anmeldenummer: 19736677.6
(22) Anmeldetag: 04.07.2019
(51) Int. Cl.: H05K 1/02, H05K 1/16, B60L 53/16, G01K 13/00, H01R 13/66, G01K 1/16, G01K 7/16, H01R 13/04

(54) **STECKVERBINDER MIT FLIP-CHIP MESSELEMENT**
PLUG-IN CONNECTOR WITH A FLIP-CHIP MEASURING ELEMENT
CONNECTEUR À ÉLÉMENT DE MESURE À PUCE RETOURNÉE

(30) Priorität: 23.07.2018 DE 202018003420 U
(43) Veröffentlichungstag der Anmeldung: 02.06.2021
(73) Patentinhaber: Heraeus Nexensos GmbH, 63801 Kleinostheim (DE)
(72) Erfinder: MUZIOL, Matthias, 63450 Hanau (DE); HECKMANN, Frank, 63450 Hanau (DE); BLEIFUSS, Martin, 63450 Hanau (DE); HELLMANN, Uwe, 63450 Hanau (DE)
(74) Vertreter: Heraeus IP
(86) Internationale Anmeldenummer: PCT/EP2019/067928
(87) Internationale Veröffentlichungsnummer: WO 2020/020591

(56) Entgegenhaltungen:
- EP-A1- 1 039 281
- WO-A1-2016/169940
- DE-A1-102010 030 769
- DE-A1-102014 111 185
- DE-B4-102010 030 769
- DE-U1-202018 002 686

## Beschreibung

Die vorliegende Erfindung betrifft einen Steckverbinder zum Trennen und Verbinden von zumindest einem elektrischen Kontakt zum Laden einer Akkueinheit eines Kraftfahrzeugs. Weiterhin betrifft die vorliegende Erfindung ein Kraftfahrzeug mit einer Akkueinheit und einem Steckverbinder, sowie eine Ladestation zum Laden einer Akkueinheit eines Kraftfahrzeugs, mit einem Steckverbinder.

Die Akkueinheit von einem Elektro- oder Hybridfahrzeug wird üblicherweise über ein Ladekabel geladen. Das Ladekabel kann beispielsweise an eine entsprechende Ladestation oder Stromtankstelle für Elektrofahrzeuge angeschlossen werden. Damit, beispielsweise, in 20 Minuten eine Akkueinheit oder Batterie mit 50 KW/h aufgeladen werden kann, muss bei Spannungen in einem Bereich von 400 V bis 600 V ein Ladestrom von ungefähr 100 A und mehr fließen. Wegen dieser hohen Ladeströme werden hohe Anforderungen an die elektrischen Steckverbinder, bzw. an den Ladestecker und die Ladebuchse, zum Laden der Akkueinheit, gestellt. Bei einer Verwendung der aus dem Stand der Technik bekannten Steckverbinder können sich die elektrisch leitenden Kontaktelemente der Steckverbinder auf einen Temperaturwert von 150°C erwärmen. Beim Laden zukünftiger Generationen von Akkueinheiten können sich die elektrisch leitenden Kontaktelemente der Steckverbinder sogar auf Temperaturwerte von 200°C bis 220°C erwärmen.

Um eine Überhitzung der Steckverbinder zu verhindern sind aus dem Stand der Technik Steckverbinder mit integrierten Temperatursensorelementen bekannt. Wenn mittels der integrierten Temperatursensorelemente eine drohende Überhitzung des Steckverbinders erkannt wird, kann der Ladestrom entsprechend gedrosselt werden, um eine Überhitzung zu vermeiden.

Beispielsweise wird in der WO 2017/211349 A1 ein Steckverbinder beschrieben, der ein Ladekabel und ein Steckergehäuse, sowie elektrisch leitende Kontaktelemente zum Trennen und Verbinden einer Akkueinheit eines Kraftfahrzeugs umfasst. Zur Überwachung der Temperatur in dem Steckverbinder ist ein Temperatursensorelement mittels eines Schrumpfschlauches an einem elektrisch leitenden Kontaktelement angeordnet, wobei der Schrumpfschlauch den Bereich des Kontaktelements und das Sensorelement des Temperatursensorelements vollständig umgibt, so dass das Temperatursensorelement einerseits wärmeleittechnisch und mechanisch mit dem Kontaktelement durch den Schrumpfschlauch verbunden ist und das Temperatursensorelement andererseits in einer Art Wärmekammer, die durch den Schrumpfschlauch gebildet wird, angeordnet ist.

Im Gegensatz zu dem in der WO 2017/211349 A1 beschrieben direkten Anordnen eines Sensorelements an einem elektrisch leitenden Kontaktelement, beschreibt die DE 10 2016 107 401 A1 ein Temperatursensorelement in einem Steckverbinder, der beabstandet zu dem elektrisch leitenden Kontaktelement angeordnet ist und eine Temperatur in einem zwischen einem Kontaktbereich und einem Anschlussbereich gelegenen Bereich des Kontaktelementes erfasst.

Weiterhin beschreiben die Dokumente WO 2012/146766 A1, US 9,484,667 B2, WO 2017/137826 A1, und WO 02/13331 A1 verschiedenartige Anordnungen von Temperatursensorelementen an oder in der Nähe von elektrisch leitenden Kontaktelementen von Steckverbindern. Das Dokument WO 2016/169940 A1 offenbart den Oberbegriff des Anspruchs 1.

Allerdings haben die aus dem Stand der Technik bekannten Lösungen den Nachteil, dass die Temperatur nicht am Ort der Entstehung, nämlich der eigentlichen Kontaktstelle an dem elektrisch leitenden Kontaktelement gemessen wird, sondern an Stellen in einem Ladestecker, die entfernt von der eigentlichen Kontaktstelle liegen. Durch die hierdurch entstehenden Wärmebrücken kann es zu einem verzögerten Ansprechen des Temperatursensorelements bei einer Überhitzung des Steckverbinders führen. Dies kann zu einer Schädigung des Steckverbinders, des Fahrzeugs oder der Ladestation führen. Weiterhin führen die verwendeten Zuleitungen aus wärmeleitfähigem Kupfer die Wärme von dem Temperatursensorelement ab und können somit die Messergebnisse verfälschen.

Aufgabe der vorliegenden Erfindung ist es daher, einen verbesserten Steckverbinder mit einem Temperatursensorelement bereitzustellen.

Diese Aufgabe wird erfindungsgemäß durch einen Steckverbinder gemäß des Gegenstands des Anspruchs 1 gelöst.

Der erfindungsgemäße Steckverbinder zum Trennen und Verbinden von zumindest einem elektrischen Kontakt zum Laden einer Akkueinheit eines Kraftfahrzeugs weist hierfür folgende Merkmale auf:
zumindest ein elektrisch leitendes Kontaktelement mit einem Kontaktbereich an einem ersten Endbereich des elektrisch leitenden Kontaktelements zum lösbaren elektrischen Verbinden mit einem korrespondierenden Kontaktelement, und mit einem Anschlussbereich an einem zweiten Endbereich des elektrisch leitenden Kontaktelements zum Verbinden mit zumindest einem elektrischen Leiter, wobei der zweite Endbereich dem ersten Endbereich gegenüberliegt; und
zumindest ein Temperatursensorelement zur Erfassung einer Temperatur des elektrisch leitenden Kontaktelements und angeordnet an dem zweiten Endbereich des elektrisch leitenden Kontaktelements, wobei das Temperatursensorelement ein Substrat mit einem ersten und
einem zweiten darauf angeordneten Anschlusselement, ein Flip-Chip Messelement und einen ersten als Wärmebremse ausgebildeten Leiterbahnabschnitt umfasst, wobei ein erster Anschluss des Flip-Chip Messelements mit dem ersten Anschlusselement über den ersten als Wärmebremse ausgebildeten Leiterbahnabschnitt elektrisch verbunden ist.

Der Begriff "Steckverbinder" kann dazu verwendet werden, um einen Stecker oder eine Steckerbuchse an einem Ladekabel oder an einer Ladestation oder an einem Kraftfahrzeug zu bezeichnen, mit einem Gehäuse, einem Steckereinsatz zum Halten von elektrisch leitenden Kontaktelementen und mit zumindest einem erfindungsgemäßen elektrisch leitenden Kontaktelement.

Mit der Erfindung ist es erstmalig gelungen einen Steckverbinder mit einer sehr guten thermischen Ankopplung des Temperatursensorelements an das elektrisch leitende Kontaktelement zur Verfügung zu stellen und mit daraus resultierenden schnelleren Ansprechzeiten des Temperatursensorelements. Vorteilhaft minimieren die als Wärmebremse ausgebildeten Leiterbahnabschnitte die Wärmeableitung vom Temperatursensorelement durch die Anschlüsse.

In einem Beispiel weist der Steckverbinder mindestens eine Sensorzuleitung auf, wobei die Sensorzuleitung an mindestens einem der Anschlusselemente mittels einer Weichlotverbindung angeordnet ist.

Vorteilhaft kann die Sensorzuleitung mittels einer Weichlotverbindung an dem Anschlusselement angeordnet werden, da das Anschlusselement wegen der erfindungsgemäßen Anordnung deutlich niedrigeren Temperaturen ausgesetzt ist als das Flip-Chip Messelement. Deshalb können mit der erfindungsgemäßen Anordnung deutlich höhere Temperaturen gemessen werden, als es eine Weichlotverbindung an einem konventionellen Temperatursensorelement zulassen würde.

In einem weiteren Beispiel weist der Steckverbinder einen zweiten als Wärmebremse ausgebildeten Leiterbahnabschnitt auf, wobei ein zweiter Anschluss des Flip-Chip Messelements über einen zweiten als Wärmebremse ausgebildeten Leiterbahnabschnitt mit dem zweiten Anschlusselement elektrisch verbunden ist, oder
der zweite Anschluss des Flip-Chip Messelements ist mit dem elektrischen Leiter verbunden.

In noch einem Beispiel verläuft der als Wärmebremse ausgebildete Leiterbahnabschnitt zumindest abschnittsweise mäanderförmig, oder weist einen ersten und einen zweiten Abschnitt auf, wobei der zweite Abschnitt gegenüber dem ersten Abschnitt einen kleineren Querschnitt aufweist.

In einem Beispiel weist das elektrisch leitende Kontaktelement an dem zweiten Endbereich eine flache Auflagefläche auf und das Temperatursensorelement ist auf der flachen Auflagefläche angeordnet.

Vorteilhaft kann hierdurch die thermische Ankopplung verbessert werden.

In einem weiteren Beispiel zur Verbesserung der thermischen Ankopplung weist eine erste Seite des Substrats, die einer zweiten Seite des Substrats mit den darauf angeordneten ersten und/oder zweiten Anschlusselementen gegenüberliegt eine konkave Aussparung auf, zum Verbinden des Temperatursensorelements mit dem zweiten Endbereich des elektrisch leitenden Kontaktelements, der eine entsprechende konvexe Geometrie aufweist.

In einem Beispiel weist der Steckverbinder ein wärmeleitfähiges Material auf, insbesondere eine Wärmeleitpaste, angeordnet zwischen dem Temperatursensorelement und dem elektrisch leitenden Kontaktelement, und/oder eine Folie, insbesondere eine Wärmeleitfolie aufweisend ein Polyimidmaterial, insbesondere ein Polymer gefüllt mit einem wärmeleitfähigen Pulver, bevorzugt Al2O3, angeordnet zwischen dem Temperatursensorelement und dem elektrisch leitenden Kontaktelement.

Vorteilhaft kann durch das Anordnen einer Wärmeleitpaste und/oder Folie die Spannungsfestigkeit zwischen dem elektrisch leitenden Kontaktelement und dem Temperatursensorelement verbessert werden.

In einem weiteren Beispiel weist der als Wärmebremse ausgebildete Leiterbahnabschnitt, insbesondere ein Leiterbahnabschnitt umfassend ein Kupfermaterial, einen Querschnitt von 50 µm x 5 µm bis 500 µm x 200 µm auf, wobei der erste und zweite Leiterbahnabschnitt auf einer Seite des Substrats, oder auf unterschiedlichen Seite des Substrats zumindest bereichsweise angeordnet sind.

Beispielsweise kann zumindest einer der Leiterbahnabschnitte über eine Durchgangsöffnung, Via, in dem Substrat mit dem Flip-Chip Messelement verbunden sein und auf einer des Flip-Chip Messelements und des zweiten Leiterbahnabschnitts gegenüberliegenden Seite des Substrats angeordnet sein.

In noch einem Beispiel ist das Temperatursensorelement an dem zweiten Endbereich des elektrisch leitenden Kontaktelements mit einem Schrumpfschlauch, einem Federbauteil und/oder einer Klammer befestigt.

In noch einem weiteren Beispiel umfasst das Substrat eine Aluminiumoxidkeramik, ein Printed Circuit Board, PCB, eine Hochtemperatur Leiterplatte, insbesondere eine Aluminiumoxidkeramik, oder einen Lead Frame, und wobei das Temperatursensorelement einen Thermistor, einen Platin-Messwiderstand, einen Silizium-Messwiderstand, ein pyroelektrisches Material, ein ferromagnetisches Material, und/oder ein faseroptisches Material umfasst.

Vorteilhaft ermöglichen besonders flache und massenarme Temperatursensorelemente eine schnelle Ansprechzeit, eine hohe Messgenauigkeit und das Erhalten von reproduzierbaren Werten.

In einem Beispiel umfasst das elektrisch leitende Kontaktelement ein elektrisch leitendes Material, insbesondere ein Kupfermaterial, und ist im Wesentlichen zylindrisch ausgestaltet.

Beispielsweise kann das elektrisch leitende Kontaktelement ein Stecker-Stift oder eine Stecker-Buchse in dem Steckverbinder sein. Hierfür ist in einem Beispiel das elektrisch leitende Kontaktelement in dem Anschlussbereich pinförmig oder buchsenförmig ausgestaltet zum lösbaren elektrischen Verbinden mit einem korrespondierenden buchsenförmigen oder pinförmigen Kontaktelement.

Die Erfindung schlägt auch ein Kraftfahrzeug mit einer Akkueinheit und zumindest einem erfindungsgemäßen Steckverbinder vor.

Weiterhin schlägt die Erfindung eine Ladestation zum Laden einer Akkueinheit eines Kraftfahrzeugs mit zumindest einem erfindungsgemäßen Steckverbinder vor.

Weitere Merkmale und Vorteile der Erfindung ergeben sich aus der nachfolgenden Beschreibung, in der bevorzugte Ausführungsformen der Erfindung anhand von schematischen Zeichnungen erläutert sind.

Dabei zeigt:
- Figur 1: eine schematische Schnittansicht eines Steckverbinders gemäß einer Ausführungsform der Erfindung;
- Figur 2: eine schematische Draufsicht auf ein Temperatursensorelement gemäß einer ersten Ausführungsform der Erfindung; und
- Figur 3: eine schematische Draufsicht auf ein Temperatursensorelement gemäß einer zweiten Ausführungsform der Erfindung.

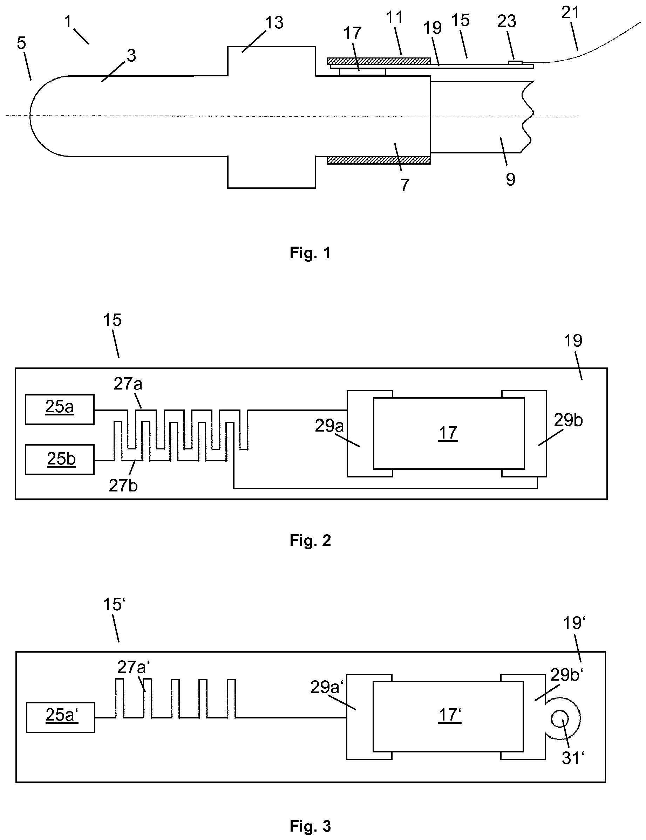

Figur 1 zeigt eine schematische Schnittansicht eines Steckverbinders 1 gemäß einer Ausführungsform der Erfindung.

Wie es in Figur 1 gezeigt wird, weist der Steckverbinder 1 zumindest ein elektrisch leitendes Kontaktelement 3 mit einem Kontaktbereich 5 zum lösbaren elektrischen Verbinden mit einem korrespondierenden Kontaktelement (nicht gezeigt in Figur 1) an einem ersten Endbereich des elektrisch leitenden Kontaktelements 3 auf. In Figur 1 ist der Kontaktbereich 5 in Form eines Stecker-Pins zur Verbindung mit einer korrespondierenden Stecker-Buchse dargestellt. Weiterhin weist das elektrisch leitende Kontaktelement 3 einen Anschlussbereich 7 zum Verbinden mit zumindest einem elektrischen Leiter 9 an einem zweiten Endbereich des elektrisch leitenden Kontaktelements 3 auf. In der gezeigten Ausführungsform liegt der zweite Endbereich dem ersten Endbereich gegenüber.

An dem Anschlussbereich 7 kann beispielsweise der elektrische Leiter 9 angelötet, angeschraubt, angecrimpt oder angeklemmt werden. In der gezeigten Ausführungsform ist das Temperatursensorelement 15 mittels eines Schrumpfschlauchs 11 an dem Anschlussbereich 7 angeordnet. In weiteren, nicht gezeigten, Ausführungsformen können hierfür auch, alternativ oder zusätzlich zu dem Schrumpfschlauch 11, Klemmen oder weitere Anschlusselemente an dem Anschlussbereich 7 angeordnet sein. Das Flip-Chip Messelement 17 ist in der gezeigten Ausführungsform mit dem elektrisch leitenden Kontaktelement 3 zumindest thermisch in Verbindung. Ein auf dem Substrat 19 des Temperatursensorelements 15 angeordnetes Anschlusselement ist mit einer Sensorzuleitung 21 mittels einer Weichlotverbindung 23 verbunden.

Weiterhin wird in Figur 1 ein an dem zweiten Endbereich des elektrisch leitenden Kontaktelements 3 angeordneter Anschlagflansch 13 gezeigt, der dazu dient, dass das elektrisch leitenden Kontaktelement 3 in einem Steckereinsatz (nicht gezeigt in Figur 1) gehalten werden kann. Abhängig von dem verwendeten Steckereinsatz kann der Anschlagflansch 13 auch anders als gezeigt ausgestaltet sein, bzw. komplett entfallen.

Der Steckverbinder 1 kann in weiteren, nicht gezeigten, Ausführungsformen weitere Komponenten aufweisen, wie beispielsweise ein Gehäuse und einen Steckereinsatz, zum Halten von dem elektrisch leitenden Kontaktelement 3, wie zum Beispiel einer Steckerbuchse.

Figur 2 zeigt eine schematische Draufsicht auf ein Temperatursensorelement 15 gemäß einer ersten Ausführungsform der Erfindung.

Auf dem Substrat 19 ist ein erstes und ein zweites Anschlusselement 25a, 25b, ein Flip-Chip Messelement 17 und ein erster und ein zweiter als Wärmebremse ausgebildeter Leiterbahnabschnitt 27a, 27b angeordnet. Wie weiterhin in der Figur 2 gezeigt, ist ein erster Anschluss 29a des Flip-Chip Messelements 17 mit dem ersten Anschlusselement 25a über den ersten als Wärmebremse ausgebildeten Leiterbahnabschnitt 27a elektrisch verbunden und ein zweiter Anschluss 29b des Flip-Chip Messelements 17 ist über den zweiten als Wärmebremse ausgebildeten Leiterbahnabschnitt 27b mit dem zweiten Anschlusselement 25b elektrisch verbunden. In der gezeigten Ausführungsform sind die Anschlusselemente 25a, 25b, das Flip-Chip Messelement 17, die Leiterbahnabschnitte 27a, 27b, die Anschlüsse 29a, 29b des Flip-Chip Messelements 17, sowie das Flip-Chip Messelements 17 alle auf einer Seite des Substrats 19 angeordnet. Die Anschlusselemente 25a, 25b, die Leiterbahnabschnitte 27a, 27b und die Anschlüsse 29a, 29b des Flip-Chip Messelements 17 können als Kupferbereiche einer Leiterplatte, PCB, ausgeformt sein. Das Flip-Chip Messelement 17 kann mittels einer bekannten C4-Technolgie, Kleben mit nicht leitfähigem Klebstoff, NCA, Kleben mit isotrop leitfähigem Klebstoff, ICA, Kleben mit anisotrop leitfähigem Klebstoff, ACA, oder einer anderen Montagetechnologie auf den Anschlüssen 29a, 29b des Substrats 19 angeordnet sein.

Wie in Figur 2 gezeigt, verlaufen beide Leiterbahnabschnitte 27a, 27b abschnittsweise mäanderförmig. In einer weiteren Ausführungsform können die Leiterbahnabschnitte auch einen ersten und einen zweiten Abschnitt aufweisen, wobei der zweite Abschnitt gegenüber dem ersten Abschnitt einen kleineren Querschnitt aufweist, um hierdurch die Wärmebremse zu realisieren.

Das gezeigte Substrat 19 kann eine Aluminiumoxidkeramik, ein Printed Circuit Board, PCB, eine Hochtemperatur Leiterplatte, insbesondere eine Aluminiumoxidkeramik, oder einen Lead Frame umfassen. Weiterhin kann das gezeigte Flip-Chip Messelement 17 einen Thermistor, einen Platin-Messwiderstand, einen Silizium-Messwiderstand, ein pyroelektrisches Material, ein ferromagnetisches Material, und/oder ein faseroptisches Material umfassen.

Figur 3 zeigt eine schematische Draufsicht auf ein Temperatursensorelement 15' gemäß einer zweiten Ausführungsform der Erfindung. Das in Figur 3 gezeigte Temperatursensorelement 15' unterscheidet sich von dem in Figur 2 gezeigten Temperatursensorelement dadurch, dass der zweite Leiterbahnabschnitt und das zweite Anschlusselement auf der Rückseite, d.h. der nicht in Figur 3 gezeigten Seite des Substrats 19' angeordnet ist. In der gezeigten Ausführungsform ist das zweite Anschlusselement über den zweiten Leiterbahnabschnitt über eine Durchgangsöffnung 31', Via, in dem Substrat mit dem Flip-Chip Messelement 17' verbunden und ist auf der nicht gezeigten Seite des Substrats 19' angeordnet.

In einer weiteren Ausführungsform entsprechend Figur 3 wird auf das zweite Anschlusselement und die zweite Leiterbahn auf der Rückseite des Substrats verzichtet und der Anschluss 29` wird elektrisch direkt mit dem Kontaktelement verbunden.

### Bezugszeichenliste

- 1: Steckverbinder
- 3: Elektrisch Leitendes Kontaktelement
- 5: Kontaktbereich
- 7: Anschlussbereich
- 9: Elektrischer Leiter
- 11: Schrumpfschlauch
- 13: Anschlagflansch
- 15, 15': Temperatursensorelement
- 17, 17': Flip-Chip Messelement
- 19, 19': Substrat
- 21: Sensorzuleitung
- 23: Weichlotverbindung
- 25a, 25a`: erstes Anschlusselement
- 25b: zweites Anschlusselement
- 27a, 27a': erster Leiterbahnabschnitt
- 27b: zweiter Leiterbahnabschnitt
- 29a, 29a': erster Anschluss
- 29b, 29b': zweiter Anschluss
- 31': Durchgangsöffnung

## Patentansprüche

1. Steckverbinder zum Trennen und Verbinden von zumindest einem elektrischen Kontakt zum Laden einer Akkueinheit eines Kraftfahrzeugs, aufweisend:
zumindest ein elektrisch leitendes Kontaktelement (3) mit einem Kontaktbereich (5) an einem ersten Endbereich des elektrisch leitenden Kontaktelements (3) zum lösbaren elektrischen Verbinden mit einem korrespondierenden Kontaktelement, und mit einem Anschlussbereich (7) an einem zweiten Endbereich des elektrisch leitenden Kontaktelements (3) zum Verbinden mit zumindest einem elektrischen Leiter (9), wobei der zweite Endbereich dem ersten Endbereich gegenüberliegt; und
zumindest ein Temperatursensorelement (15, 15') zur Erfassung einer Temperatur des elektrisch leitenden Kontaktelements (3),
wobei das Temperatursensorelement (15, 15') ein Substrat (19, 19`) mit einem ersten und einem zweiten darauf angeordneten Anschlusselement (25a, 25a`, 25b), ein Flip-Chip Messelement (17, 17`) und einen ersten Leiterbahnabschnitt (27a, 27a') umfasst, wobei ein erster Anschluss (29a, 29a`) des Flip-Chip Messelements (17, 17`) mit dem ersten Anschlusselement (25a, 25a`) über den ersten Leiterbahnabschnitt (27a, 27a`) elektrisch verbunden ist,
**dadurch gekennzeichnet, dass**
das Temperatursensorelement (15, 15') an dem zweiten Endbereich des elektrisch leitenden Kontaktelements (3) angeordnet ist, und dass
der erste Leiterbahnabschnitt (27a, 27a') als Wärmebremse ausgebildet ist.

2. Steckverbinder nach Anspruch 1, aufweisend mindestens eine Sensorzuleitung (21), wobei die Sensorzuleitung (21) an mindestens einem der Anschlusselemente (25a, 25a`, 25b) mittels einer Weichlotverbindung (23) angeordnet ist.

3. Steckverbinder nach Anspruch 2, aufweisend einen zweiten als Wärmebremse ausgebildeten Leiterbahnabschnitt (27b), wobei ein zweiter Anschluss (29b, 29b`) des Flip-Chip Messelements (17, 17`) über einen zweiten als Wärmebremse ausgebildeten Leiterbahnabschnitt (27b) mit dem zweiten Anschlusselement (25b) elektrisch verbunden ist, oder
der zweite Anschluss (29b, 29b`) des Flip-Chip Messelements (17, 17`) mit dem elektrischen Leiter (9) verbunden ist.

4. Steckverbinder nach einem der vorangehenden Ansprüche, wobei der als Wärmebremse ausgebildete Leiterbahnabschnitt (27a, 27a`, 27b) zumindest abschnittsweise mäanderförmig verläuft, oder einen ersten und einen zweiten Abschnitt aufweist, wobei der zweite Abschnitt gegenüber dem ersten Abschnitt einen kleineren Querschnitt aufweist.

5. Steckverbinder nach einem der Ansprüche 1 bis 4, wobei das elektrisch leitende Kontaktelement (3) an dem zweiten Endbereich eine flache Auflagefläche aufweist und das Temperatursensorelement (15, 15') auf der flachen Auflagefläche angeordnet ist.

6. Steckverbinder nach einem der Ansprüche 1 bis 4, wobei eine erste Seite des Substrats (19, 19`), die einer zweiten Seite des Substrats (19, 19`) mit den darauf angeordneten ersten und/oder zweiten Anschlusselementen (25a, 25a`, 25b) gegenüberliegt eine konkave Aussparung aufweist, zum Verbinden des Temperatursensorelements (15, 15') mit dem zweiten Endbereich des elektrisch leitenden Kontaktelements (3), der eine entsprechende konvexe Geometrie aufweist.

7. Steckverbinder nach einem der vorangehenden Ansprüche, aufweisend ein wärmeleitfähiges Material, insbesondere eine Wärmeleitpaste, angeordnet zwischen dem Temperatursensorelement (15, 15`) und dem elektrisch leitenden Kontaktelement (3), und/oder eine Folie, insbesondere eine Wärmeleitfolie aufweisend ein Polyimidmaterial, insbesondere ein Polymer gefüllt mit einem wärmeleitfähigen Pulver, bevorzugt AI2O3, angeordnet zwischen dem Temperatursensorelement (15, 15') und dem elektrisch leitenden Kontaktelement (3).

8. Steckverbinder nach einem der vorangehenden Ansprüche, wobei der als Wärmebremse ausgebildete Leiterbahnabschnitt (27a, 27a`, 27b), insbesondere ein Leiterbahnabschnitt (27a, 27a`, 27b) umfassend ein Kupfermaterial, einen Querschnitt von 50 µm x 5 µm bis 500 µm x 200 µm aufweist, wobei der erste und zweite Leiterbahnabschnitt (27a, 27a`, 27b) auf einer Seite des Substrats (19, 19`), oder auf unterschiedlichen Seite des Substrats (19, 19`) zumindest bereichsweise angeordnet sind.

9. Steckverbinder nach einem der vorangehenden Ansprüche, wobei das Temperatursensorelement (15, 15') an dem zweiten Endbereich des elektrisch leitenden Kontaktelements (3) mit einem Schrumpfschlauch (11), einem Federbauteil und/oder einer Klammer befestigt ist.

10. Steckverbinder nach einem der vorangehenden Ansprüche, wobei das Substrat (19, 19`) eine Aluminiumoxidkeramik, ein Printed Circuit Board, PCB, eine Hochtemperatur Leiterplatte, insbesondere eine Aluminiumoxidkeramik, oder einen Lead Frame umfasst, und wobei das Temperatursensorelement (15, 15`) einen Thermistor, einen Platin-Messwiderstand, einen Silizium-Messwiderstand, ein pyroelektrisches Material, ein ferromagnetisches Material, und/oder ein faseroptisches Material umfasst.

11. Steckverbinder nach einem der vorangehenden Ansprüche, wobei das elektrisch leitende Kontaktelement (3) ein elektrisch leitendes Material, insbesondere ein Kupfermaterial, umfasst und im Wesentlichen zylindrisch ausgestaltet ist, und wobei das elektrisch leitende Kontaktelement (3) in dem Anschlussbereich (7) pinförmig oder buchsenförmig ausgestaltet ist zum lösbaren elektrischen Verbinden mit einem korrespondierenden buchsenförmigen oder pinförmigen Kontaktelement.

12. Ein Kraftfahrzeug mit einer Akkueinheit, aufweisend zumindest einen Steckverbinder nach einem der Ansprüche 1 bis 11.

13. Eine Ladestation zum Laden einer Akkueinheit eines Kraftfahrzeugs, aufweisend zumindest einen Steckverbinder nach einem der Ansprüche 1 bis 11.

## Claims

1. A plug-in connector for disconnecting and connecting at least one electrical contact for charging a battery unit of a motor vehicle, comprising:
at least one electrically conductive contact element (3) having a contact region (5) at a first end region of the electrically conductive contact element (3) for detachably electrically connecting to a corresponding contact element, and having a terminal region (7) at a second end region of the electrically conductive contact element (3) for connecting to at least one electrical conductor (9), the second end region being opposite the first end region; and
at least one temperature sensor element (15, 15') for detecting a temperature of the electrically conductive contact element (3), the temperature sensor element (15, 15') comprising a substrate (19, 19') that has a first and a second terminal element (25a, 25a', 25b) arranged thereon, a flip-chip measuring element (17, 17') and a first conductor track portion (27a, 27a'),
a first terminal (29a, 29a') of the flip-chip measuring element (17, 17') being electrically connected to the first terminal element (25a, 25a') via the first conductor track portion (27a, 27a'),
**characterized in that**
the temperature sensor element (15, 15') is arranged on the second end region of the electrically conductive contact element (3), and **in that**
the first conductor track portion (27a, 27a') is designed as a heat brake.

2. The plug-in connector according to claim 1, comprising at least one sensor feed line (21), wherein the sensor feed line (21) is arranged on at least one of the terminal elements (25a, 25a', 25b) by means of a soft solder connection (23).

3. The plug-in connector according to claim 2, comprising a second conductor track portion (27b) designed as a heat brake, wherein a second terminal (29b, 29b') of the flip-chip measuring element (17, 17') is electrically connected to the second terminal element (25b) via a second conductor track portion (27b) designed as a heat brake, or
the second terminal (29b, 29b') of the flip-chip measuring element (17, 17') is connected to the electrical conductor (9).

4. The plug-in connector according to any of the preceding claims, wherein the conductor track portion (27a, 27a', 27b) designed as a heat brake extends in a meandering manner at least in portions, or comprises a first and a second portion, the second portion having a smaller cross section than the first portion.

5. The plug-in connector according to any of claims 1 to 4, wherein the electrically conductive contact element (3) comprises a flat support surface on the second end region and the temperature sensor element (15, 15') is arranged on the flat support surface.

6. The plug-in connector according to any of claims 1 to 4, wherein a first side of the substrate (19, 19') that is opposite a second side of the substrate (19, 19') having the first and/or second terminal elements (25a, 25a', 25b) arranged thereon comprises a concave recess for connecting the temperature sensor element (15, 15') to the second end region of the electrically conductive contact element (3), which second end region has a corresponding convex geometry.

7. The plug-in connector according to any of the preceding claims, comprising a thermally conductive material, in particular a heat-conducting paste, arranged between the temperature sensor element (15, 15') and the electrically conductive contact element (3), and/or a film, in particular a heat-conducting film comprising a polyimide material, in particular a polymer filled with a thermally conductive powder, preferably AI2O3, arranged between the temperature sensor element (15, 15') and the electrically conductive contact element (3).

8. The plug-in connector according to any of the preceding claims, wherein the conductor track portion (27a, 27a', 27b) designed as a heat brake, in particular a conductor track portion (27a, 27a', 27b) comprising a copper material, has a cross section of from 50 µm x 5 µm to 500 µm x 200 µm, the first and the second conductor track portion (27a, 27a', 27b) being arranged at least in regions on one side of the substrate (19, 19') or on different sides of the substrate (19, 19').

9. The plug-in connector according to any of the preceding claims, wherein the temperature sensor element (15, 15') is fastened to the second end region of the electrically conductive contact element (3) by means of a heat-shrink tube (11), a spring component and/or a clamp.

10. The plug-in connector according to any of the preceding claims, wherein the substrate (19, 19') comprises an aluminum oxide ceramic material, a printed circuit board, PCB, a high-temperature circuit board, in particular an aluminum oxide ceramic material, or a lead frame, and wherein the temperature sensor element (15, 15') comprises a thermistor, a platinum measuring resistor, a silicon measuring resistor, a pyroelectric material, a ferromagnetic material, and/or a fiber-optic material.

11. The plug-in connector according to any of the preceding claims, wherein the electrically conductive contact element (3) comprises an electrically conductive material, in particular a copper material, and is substantially cylindrical, and wherein the electrically conductive contact element (3), in the terminal region (7), is pin-shaped or socket-shaped for detachably electrically connecting to a corresponding socket-shaped or pin-shaped contact element.

12. A motor vehicle having a battery unit, comprising at least one plug-in connector according to any of claims 1 to 11.

13. A charging station for charging a battery unit of a motor vehicle, comprising at least one plug-in connector according to any of claims 1 to 11.

## Revendications

1. Connecteur permettant la déconnexion et la connexion d'au moins un contact électrique permettant de charger une unité d'accumulateur d'un véhicule automobile, présentant :
au moins un élément de contact électriquement conducteur (3) comportant une zone de contact (5) au niveau d'une première zone d'extrémité de l'élément de contact électriquement conducteur (3) pour la connexion électrique amovible avec un élément de contact correspondant, et comportant une zone de borne (7) au niveau d'une seconde zone d'extrémité de l'élément de contact électriquement conducteur (3) pour la connexion avec au moins un conducteur électrique (9), la seconde zone d'extrémité étant opposée à la première zone d'extrémité ; et
au moins un élément de capteur de température (15, 15`) permettant de détecter une température de l'élément de contact électriquement conducteur (3), l'élément de capteur de température (15, 15`) comprenant un substrat (19, 19`) sur lequel sont disposés un premier et un second élément de borne (25a, 25a', 25b), un élément de mesure à puce retournée (17, 17`) et une première section de piste conductrice (27a, 27a'),
une première borne (29a, 29a`) de l'élément de mesure à puce retournée (17, 17`) étant reliée électriquement au premier élément de borne (25a, 25a`) par l'intermédiaire de la première section de piste conductrice (27a, 27a'),
**caractérisé en ce que**
l'élément de capteur de température (15, 15`) est disposé au niveau de la seconde zone d'extrémité de l'élément de contact électriquement conducteur (3), **et en ce que** la première section de piste conductrice (27a, 27a`) est réalisée en tant que frein thermique.

2. Connecteur selon la revendication 1, présentant au moins une alimentation de capteur (21), l'alimentation de capteur (21) étant disposée sur au moins l'un des éléments de borne (25a, 25a', 25b) au moyen d'une liaison par brasage tendre (23).

3. Connecteur selon la revendication 2, présentant une seconde section de piste conductrice (27b) réalisée en tant que frein thermique, une seconde borne (29b, 29b') de l'élément de mesure à puce retournée (17, 17`) étant reliée électriquement au second élément de borne (25b) par l'intermédiaire d'une seconde section de piste conductrice (27b) réalisée en tant que frein thermique, ou
la seconde borne (29b, 29b`) de l'élément de mesure à puce retournée (17, 17`) étant reliée au conducteur électrique (9).

4. Connecteur selon l'une des revendications précédentes, dans lequel la section de piste conductrice (27a, 27a`, 27b) réalisée en tant que frein thermique s'étend au moins dans certaines sections sous forme de méandres, ou présente une première et une seconde section, la seconde section présentant une section transversale plus petite que la première section.

5. Connecteur selon l'une des revendications 1 à 4, dans lequel l'élément de contact électriquement conducteur (3) présente une surface d'appui plate au niveau de la seconde zone d'extrémité et l'élément de capteur de température (15, 15`) est disposé sur la surface d'appui plate.

6. Connecteur selon l'une des revendications 1 à 4, dans lequel une première face du substrat (19, 19`) opposée à une seconde face du substrat (19, 19`) sur laquelle sont disposés les premier et/ou second éléments de borne (25a, 25a`, 25b) présente un évidement concave, pour la liaison de l'élément de capteur de température (15, 15`) à la seconde zone d'extrémité de l'élément de contact électriquement conducteur (3), laquelle présente une géométrie convexe correspondante.

7. Connecteur selon l'une des revendications précédentes, présentant un matériau thermoconducteur, en particulier une pâte thermoconductrice, disposé entre l'élément de capteur de température (15, 15`) et l'élément de contact électriquement conducteur (3), et/ou une feuille, en particulier une feuille thermoconductrice présentant un matériau polyimide, en particulier un polymère rempli d'une poudre thermoconductrice, de préférence AI2O3, disposée entre l'élément de capteur de température (15, 15`) et l'élément de contact électriquement conducteur (3).

8. Connecteur selon l'une des revendications précédentes, dans lequel la section de piste conductrice (27a, 27a`, 27b) réalisée en tant que frein thermique, en particulier une section de piste conductrice (27a, 27a', 27b) comprenant un matériau de cuivre, présente une section transversale de 50 µm × 5 µm à 500 µm × 200 µm, les première et seconde sections de piste conductrice (27a, 27a', 27b) étant disposées au moins dans certaines zones sur une face du substrat (19, 19`) ou sur une face différente du substrat (19, 19`).

9. Connecteur selon l'une des revendications précédentes, dans lequel l'élément de capteur de température (15, 15`) est fixé au niveau de la seconde zone d'extrémité de l'élément de contact électriquement conducteur (3) avec une gaine thermorétractable (11), une pièce de ressort et/ou une pince.

10. Connecteur selon l'une des revendications précédentes, dans lequel le substrat (19, 19`) comprend une céramique d'oxyde d'aluminium, une carte de circuit imprimé, PCB, une plaquette à circuit imprimé haute température, en particulier une céramique d'oxyde d'aluminium, ou une grille de connexion, et l'élément de capteur de température (15, 15`) comprenant une thermistance, une résistance de mesure en platine, une résistance de mesure en silicium, un matériau pyroélectrique, un matériau ferromagnétique et/ou un matériau à fibres optiques.

11. Connecteur selon l'une des revendications précédentes, dans lequel l'élément de contact électriquement conducteur (3) comprend un matériau électriquement conducteur, en particulier un matériau de cuivre, et est sensiblement cylindrique, et l'élément de contact électriquement conducteur (3) étant en forme de broche ou en forme de douille dans la zone de borne (7) pour une connexion électrique amovible avec un élément de contact correspondant en forme de douille ou en forme de broche.

12. Véhicule automobile comportant une unité d'accumulateur, présentant au moins un connecteur selon l'une des revendications 1 à 11.

13. Station de charge permettant de charger une unité d'accumulateur d'un véhicule automobile, présentant au moins un connecteur selon l'une des revendications 1 à 11.
